(19) Europäisches Patentamt
European Patent Office
Office européen des brevets

(11) Veröffentlichungsnummer : **0 073 444**
**B1**

(12) # EUROPÄISCHE PATENTSCHRIFT

(45) Veröffentlichungstag der Patentschrift : **05.03.86**

(51) Int. Cl.[4] : **G 03 C 1/68**, G 03 F 7/10

(21) Anmeldenummer : **82107706.2**

(22) Anmeldetag : **23.08.82**

(54) **Durch Strahlung polymerisierbares Gemisch und daraus hergestelltes photopolymerisierbares Kopiermaterial.**

(30) Priorität : **28.08.81 DE 3134123**

(43) Veröffentlichungstag der Anmeldung : **09.03.83 Patentblatt 83/10**

(45) Bekanntmachung des Hinweises auf die Patenterteilung : **05.03.86 Patentblatt 86/10**

(84) Benannte Vertragsstaaten : **AT BE CH DE FR GB IT LI NL SE**

(56) Entgegenhaltungen :
**EP-A- 0 002 040**
**EP-A- 0 005 750**
**DE-A- 2 207 853**
**DE-A- 2 613 098**

(73) Patentinhaber : **HOECHST AKTIENGESELLSCHAFT**
**Postfach 80 03 20**
**D-6230 Frankfurt am Main 80 (DE)**

(72) Erfinder : **Geissler, Ulrich, Dr. Dipl.-Ing.**
**Ruprechtstrasse 22**
**D-6000 Frankfurt/Main (DE)**
Erfinder : **Herwig, Walter, Dr. Dipl.-Ing.**
**Hasenpfad 7**
**D-6232 Bad-Soden 2 (DE)**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

EP 0 073 444 B1

**Beschreibung**

Die Erfindung betrifft ein durch Strahlung polymerisierbares Gemisch, das als wesentliche Bestandteile

a) eine Verbindung mit mindestens zwei endständigen ethylenisch ungesättigten Gruppen, die durch radikalisch initiierte Additionskettenpolymerisation ein vernetztes Polymerisat zu bilden vermag,

b) ein gesättigtes polymeres Bindemittel, das wasserunlöslich und in wäßrig-alkalischen Lösungen löslich ist, und

c) einen durch Strahlung aktivierbaren Polymerisationsinitiator

enthält und das bevorzugt als trocken übertragbares Photoresistmaterial zur Herstellung von Lötstopmasken verwendet wird.

Leiterplatten mit ein- und doppelseitigem, vor allem aber durchkontaktiertem Aufbau, werden vor dem Löten mit einer Lötstopmaske versehen. Durch das Aufbringen solcher Masken bleiben nur die Lötaugen offen, wodurch Zinn beim Löten eingespart wird. Auch wird beim Lötvorgang ein Teil der Lötwärme vom Werkstück ferngehalten, so daß die beim Bestücken der Leiterplatten eingesetzten hitzeempfindlichen Bauelemente während des Lötens nicht geschädigt werden. Nicht zuletzt aber erfüllen Lötstopmasken die wichtige Funktion, alle Bereiche des Schaltbildes abzudecken, die mit dem Lötmetall nicht in Kontakt treten dürfen, um beispielsweise zu verhindern, daß sich — für ein Leitersystem tödliche — Leitungsbrücken zwischen den einzelnen Leiterbahnen bilden können.

Um diesen recht komplexen Forderungen zu genügen, kamen in der Vergangenheit unterschiedliche Verfahren und Produkte unterschiedlicher Darreichungsform zur Anwendung.

Aus den vorangestellten Ausführungen erhellt, daß Lötstopmasken ein an den vorgegebenen Leiterbahnen orientiertes Bildmuster aufweisen müssen. Weit verbreitet in der Praxis ist der Brauch, Lötstopmasken nach der Technik des Siebdruckes zu applizieren ; nach dieser Methode lassen sich aus Masken größerer Schichtdicken aufbringen, womit vor allem sichergestellt werden kann, daß die Leiterbahnen gut umhüllt und eingebettet werden.

Diese nach dem Siebdruckverfahren hergestellten Masken stoßen an eine im System begründete Grenze, nämlich dann, wenn die Abstände der Leiterbahnen verringert werden, so daß die relativ groben Bildstrukturen des Siebdruckes der Feinleitertechnik nicht mehr gerecht werden können.

In neuerer Zeit wurden deshalb in zunehmenden Maße Lötstopmasken nach der Photoresisttechnik hergestellt. Ebenso wie bei der Herstellung gedruckter Schaltungen werden hier thermoplastische photopolymerisierbare Schichten unter Druck und Erwärmen auf die Leiterplatte laminiert und bildmäßig an den Stellen durch Belichten gehärtet, an denen die Leiterplatte abgedeckt werden soll. Durch Auswaschen der unbelichteten Schichtstellen erhält man die Lötstopmaske. Dieses Verfahren ermöglicht höhere Bildauflösungen als das Siebdruckverfahren.

Geeignete Materialien dieser Art sind z. B. in der DE-A 27 47 947 beschrieben. Es handelt sich hierbei um photopolymerisierbare Schichten, die zur Verbesserung der Flammwidrigkeit eine bestimmte Menge gebundenes Halogen enthalten. Ein ähnliches Material ist in der EP-A 15 004 beschrieben, das sich trocken durch mechanisches Trennen von belichteten und unbelichteten Schichtbereichen entwickeln läßt (« peel-apart-Verfahren »). Schließlich wird in der EP-A 2040 ein für den gleichen Zweck bestimmtes lichthärtbares Material beschrieben, bei dem als lichtempfindliche Verbindungen nicht näher bezeichnete lichtempfindliche Epoxyharze verwendet werden.

Die für diesen Zweck bekannten und verwendeten photopolymerisierbaren Gemische werden trocken und unter Erwärmen auf die zu maskierende Leiterplatte übertragen und müssen deshalb notwendig thermoplastisch sein. Diese Eigenschaft ist jedoch nachteilig bei der Verwendung als Lötstopmasken, da diese Temperaturen oberhalb 200 °C ohne Zersetzung und ohne zu starkes Erweichen oder gar Schmelzen überstehen müssen. Zwar wird die Photopolymerschicht an den belichteten Stellen durch vernetzende Polymerisation wesentlich gehärtet, und diese Lichthärtung läßt sich durch Nachbelichten der entwickelten Bildschablone in bekannter Weise noch verstärken. Es bleibt jedoch grundsätzlich eine Erweichungstendenz beim Erwärmen von allen bekannten photopolymerisierbaren Schichten.

Um diesen Nachteil zu beheben, wurde in der EP-A2-63304 (Priorität : 13.4.81 ; Anmeldetag : 5.4.82 ; Veröffentlichungstag : 27.10.82) vorgeschlagen, dem photopolymerisierbaren Gemisch für die Herstellung der Lötstopmaske eine Bis-Epoxyverbindung zuzusetzen und die lichtgehärtete Bildschablone nach dem Entwickeln durch Erhitzen nachzuhärten. Die Epoxyverbindung wird dazu in üblicher Weise im Beschichtungsgemisch gelöst. Nach diesem Verfahren werden sehr temperaturbeständige Lötstopmasken erhalten. Das photopolymerisierbare Gemisch hat jedoch den Nachteil einer geringeren Lagerfähigkeit gegenüber einem sonst gleichen Gemisch, das keine Epoxyverbindung enthält.

Aufgabe der Erfindung war es, zur Herstellung von thermisch nachhärtbaren Bildschablonen geeignete photopolymerisierbare Gemische vorzuschlagen, die im unbelichteten Zustand eine hohe Lagerfähigkeit aufweisen.

Erfindungsgemäß wird ein durch Strahlung polymerisierbares Gemisch vorgeschlagen, das

a) eine Verbindung mit mindestens zwei endständigen ethylenisch ungesättigten Gruppen, die durch radikalisch initiierte Additionskettenpolymerisation ein vernetztes Polymerisat zu bilden vermag,

b) ein gesättigtes polymeres Bindemittel, das wasserunlöslich und in wäßrig-alkalischen Lösungen löslich ist, und

c) einen durch Strahlung aktivierbaren Polymerisationsinitiator

enthält.

Das erfindungsgemäße Gemisch ist dadurch gekennzeichnet, daß es zusätzlich

d) eine mit dem polymeren Bindemittel b, mit dem Polymerisationsprodukt der Verbindung a und/oder mit sich selbst thermisch vernetzbare Verbindung enthält, die, sofern sie als vernetzende Gruppen Epoxygruppen enthält, mindestens drei Epoxygruppen aufweist.

Als Verbindungen, die mit dem Bindemittel, dem Polymerisationsprodukt der ethylenisch ungesättigten Verbindung und/oder mit sich selbst thermisch vernetzbar sind, sind bevorzugt solche geeignet, die als vernetzende Gruppen Epoxygruppen oder Gruppen der Formel $—CH_2—O—R$ enthalten, worin R ein Wasserstoffatom, eine niedere Alkyl-, Acyl- oder Hydroxyalkylgruppe ist und in denen die Gruppen $—CH_2OR$ an einem Stickstoffatom eines offenkettigen oder cyclischen Säureamids oder an einem aromatischen Kohlenstoffatom einer zur Kondensation mit Formaldehyd befähigten Verbindung stehen. Die organischen Reste R enthalten im allgemeinen 1 bis 4, bevorzugt 1 oder 2 Kohlenstoffatome.

Die vernetzbaren Verbindungen sind in dem Gemisch gewöhnlich in einer Menge von 0,5 bis 30, vorzugsweise 1 bis 8 Gew.-%, bezogen auf seine nichtflüchtigen Bestandteile, enthalten.

Die vernetzbare Verbindung sollte vorteilhaft mindestens zwei vernetzende Gruppen enthalten. Die Epoxyverbindungen müssen mindestens drei Epoxygruppen aufweisen. Vorteilhaft für die Erzielung einer ausreichenden Lagerfähigkeit ist es, wenn die Epoxyverbindung in dem Beschichtungslösemittel praktisch unlöslich ist, d. h. daß sie in dem Beschichtungsgemisch mindestens zum größten Teil dispergiert und nicht gelöst vorliegt. Durch die hierdurch bewirkte heterogene Verteilung in der fertigen photopolymerisierbaren Schicht wird anscheinend eine vorzeitige Vernetzungsreaktion weitgehend unterdrückt. Verbindungen mit weniger reaktionsfähigen Epoxygruppen, z. B. hochmolekulare Epoxyverbindungen, können auch im Beschichtungsgemisch löslich sein.

Die Verbindungen mit vernetzenden Gruppen $—CH_2OR$ können sowohl in gelöster als auch in dispergierter Form vorliegen. Ihre Reaktionsfähigkeit bei normaler Umgebungstemperatur reicht offenbar nicht zu einer vorzeitigen Vernetzung in der Schicht aus. Von diesen Verbindungen werden besonders solche mit R = H oder Methyl bevorzugt. Ferner werden die Derivate cyclischer Säureamide, z. B. von Melamin, bevorzugt.

Allgemein werden Verbindungen mit einer größeren Anzahl von vernetzenden Gruppen besonders bevorzugt.

Grundsätzlich ist es auch möglich, vernetzbar Verbindungen zu verwenden, die sehr reaktionsfähig sind und sich in dem Beschichtungsgemisch lösen. In diesem Falle kann eine vorzeitige Reaktion dadurch verhindert werden, daß diese Verbindungen in eine im Beschichtungslösemittel unlösliche Hüllsubstanz eingekapselt werden, die unterhalb der Nacherhitzungstemperatur schmilzt oder erweicht.

Als lösliche vernetzbare Verbindungen sind insbesondere teilweise oder vollständig veretherte Polyhydroxymethylmelamine, wie Hexa-methoxymethyl-melamin ; Verbindungen folgender Formel

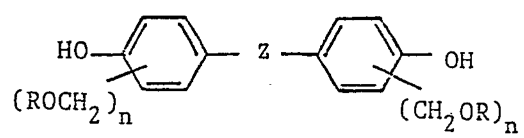

worin Z = O, S, $C_1$-$C_8$-Alkylen, z. B. $CH_2$ und $C(CH_3)_2$, oder $SO_2$, R ein H-Atom, eine niedere Alkyl- oder Acylgruppe und n = 1 oder 2 bedeutet ; oder Homo- und Copolymere von Glycidylmethacrylat geeignet.

Beispiele für geeignete vernetzbare Verbindungen sind :

N-Methylolverbindungen organischer Säureamide

N,N'-Dimethylolharnstoff,
N,N'-Dimethyloloxalsäurediamid,
N,N'-Dimethylolmalonsäurediamid,
N,N'-Dimethylolbernsteinsäurediamid,
N,N'-Dimethylolsebazinsäurediamid,
N,N',N''-Trimethylolcitronensäuretrisamid,
1,3-Dimethylol-imidazolidin-2-on,
1,3-Dimethylol-4,5-dihydroxy-imidazolidin-2-on,
1,3-Dimethylol-perhydropyrimidin-2-on,
Trimethylolmelamin,
Tetramethylolmelamin,
Hexamethylolmelamin,
1,3-Dimethylol-5-methyl-perhydro-1,3,5-triazin-2-on,
1,3-Dimethylol-5-allyl-perhydro-1,3,5-triazin-2-on,

1,3-Dimethylol-5-butyl-perhydro-1,3,5-triazin-2-on,
1,2-Bis-[1,3-dimethylol-perhydro-1,3,5-triazin-2-on-5-yl]ethan,
Tetramethylol-hydrazindicarbonsäurediamid,
N,N'-Dimethylol-terephthalsäurediamid,
N,N'-Dimethylol-benzol-1,3-disulfonsäurediamid,
Tetramethylol-glycoluril.

C-Methylolverbindungen von Phenolen, Phenolethern und aromatischen Kohlenwasserstoffen

2,4,6-Trimethylol-phenol,
2,6-Dimethylol-4-methyl-anisol,
2,6-Dimethylol-4-methyl-phenol,
1,3-Dimethylol-4,6-diisopropyl-benzol,
2,2-Bis-(4-hydroxy-3,5-dimethylol-phenyl)-propan,
3,3'-Dimethylol-4,4'-dihydroxy-diphenylsulfon,

Anstelle der genannten Methylolverbindungen können auch z. B. die entsprechenden Methyl- Ethyl- oder Butylether, Essig- oder Propionsäureester verwendet werden. Beispiele sind :

4,4'-Bis-methoxymethyl-diphenylether,
Tris-methoxymethyl-diphenylether,
Tetrakis-methoxymethyl-hydrazindicarbonsäurediamid,
Tetrakis-methoxymethyl-glycoluril,
Tetrakis-hydroxyethoxymethyl-glycoluril,
Bis-acetoxymethyl-diphenylether,
Hexamethoxymethylmelamin.

Als Beispiele für in der Beschichtungslösung unlösliche Verbindungen sind zu nennen : Triglycidylisocyanurat, Hexamethylolmelamin und Dimethylolharnstoff.

Als aktinische Strahlung, gegenüber der das erfindungsgemäße Gemisch empfindlich ist, kommt jede elektromagnetische Strahlung in Betracht, deren Energie zur Auslösung einer Polymerisation ausreicht. Geeignet sind insbesondere sichtbares und ultraviolettes Licht, Röntgen-, γ- und Elektronenstrahlung. Auch Laserstrahlung im sichtbaren und UV-Bereich kann verwendet werden. Bevorzugt wird kurzwelliges sichtbares und nahes UV-Licht.

Als polymerisierbare Verbindungen (a) werden im allgemeinen Ester der Acryl- oder Methacrylsäure mit mehrwertigen, vorzugsweise primären, Alkoholen verwendet. Der Alkohol sollte 2 bis 4 Hydroxygruppen enthalten, da durch mehrfach ungesättigte Verbindungen die erwünschte Vernetzungswirkung erreicht wird. In untergeordneter Menge können auch Ester von einwertigen oder mehr als vierwertigen Alkoholen im Gemisch enthalten sein. Beispiele für geeignete mehrwertige Alkohole sind Ethylenglykol, Propylenglykol, Butandiol-1,4, Butandiol-1,3, Diethylenglykol, Triethylenglykol, Polyethylenglykole oder Polypropylenglykole mit Molekulargewichten von etwa 200 bis 1 000, Neopentylglykol, Trimethylolethan und -propan, Pentaerythrit und oxyethylierte Bisphenol-A-Derivate. Es sind ferner die niedermolekularen, Urethangruppen enthaltenden Bis-acrylate und Bismethacrylate geeignet, die durch Umsetzen von 2 Mol Hydroxyalkylacrylat oder -methacrylat mit 1 Mol eines aliphatischen oder cycloaliphatischen Diisocyanats, z. B. 2,2,4-Trimethyl-hexamethylendiisocyanat, erhalten werden. Derartige Urethangruppen enthaltende Monomere sind in der US-A 4 088 498 beschrieben. Ähnlich geeignete Monomere sind in der DE-A 28 22 190 und der EP-A2-54700 (Priorität : 22.12.80 ; Anmeldetag : 27.10.81 ; Veröffentlichungstag : 30.6.82) beschrieben.

Mit Vorteil werden Gemische unterschiedlicher Monomerer verwendet. Dabei hat es sich besonders bewährt, Monomere der oben angegebenen Art mit höhermolekularen, Urethangruppen enthaltenden Monomeren der allgemeinen Formel

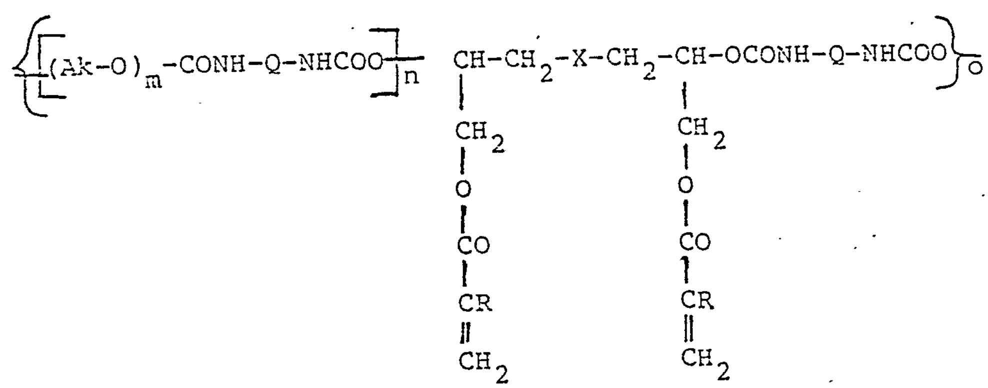

zu kombinieren, wobei

Q ein zweiwertiger ein- oder zweikerniger aromatischer Rest, der unsubstituiert oder durch niedere

Alkylgruppen substituiert ist und der als Bindeglied eine niedere Alkylengruppe enthalten kann,

X eine der Gruppen

—O—Ph—X'—Ph—O— und

—OOC—$(CH_2)_y$—COO—,

wobei Ph eine gegebenenfalls substituierte Phenylengruppe, X' eine Alkylengruppe mit 1-4 Kohlenstoffatomen und y eine Zahl von 2 bis 12 ist,

R ein Wasserstoffatom oder eine Methylgruppe,

Ak ein Alkylenrest mit 2-4 Kohlenstoffatomen,

m eine Zahl von 4 bis 50,

n eine Zahl von 1 bis 6 und

o eine Zahl von 4 bis 20 ist.

Die Herstellung dieser Polyetheresterurethane erfolgt in bekannter Weise durch Umsetzen von oligomeren Diisocyanaten der Formel

$$OCN—Q—[NHCOO—(AkO)_mCONH—Q—]_nNCO$$

mit Bis-acrylsäureester-diolen der Formel

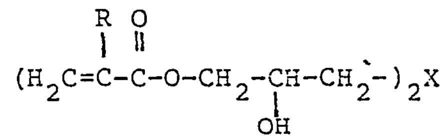

Die Herstellung und Verwendung dieser Verbindungen ist in der EP-A1-48913 (Priorität : 29.9.80 ; Anmeldetag : 19.9.81 ; Veröffentlichungstag : 7.4.82) beschrieben.

Diese Polyurethane haben im allgemeinen reduzierte spezifische Viskositäten (RSV), gemessen an 1 %igen Lösungen in Dimethylformamid bei 25 °C, von 0,15 bis 1,4 dl/g.

Bevorzugt werden Produkte mit RSV-Werten im Bereich von 0,2 bis 0,9 dl/g.

Bevorzugte mittlere Werte von m liegen bei 8-20, von n bei 2-4, von o bei 5-12 und von y bei 2-6.

X' ist eine Alkylengruppe, in der die freien Valenzen bevorzugt an einem C-Atom stehen. Bevorzugte Gruppen sind Methylen-, 1,1-Ethylen- und 2,2-Propylengruppen. R ist vorzugsweise eine Methylgruppe.

Die Gesamtmenge an polymerisierbaren Verbindungen (a) liegt zwischen 20 und 50, vorzugsweise zwischen 25 bis 45 Gew.-%, bezogen auf die nichtflüchtigen Anteile des Gemischs. Von dieser Menge können 2 bis 20, bevorzugt 5 bis 10 Gew.-%, auf die gleiche Basis bezogen, aus Polyurethanen der oben angegebenen allgemeinen Formel bestehen.

Die erfindungsgemäßen Gemische enthalten ferner ein polymeres, gesättigtes, wasserunlösliches, in wäßrig-alkalischen Lösungen lösliches Bindemittel. Als alkalilöslichmachende Gruppen können die Bindemittel Phosphonsäure-, Sulfonsäure-, Sulfonamid-, Carbonsäureanhydrid- und bevorzugt Carboxylgruppen enthalten. Bevorzugte Bindemittel sind Mischpolymerisate aus Methacrylsäure und Alkylmethacrylaten und gegebenenfalls noch Styrol oder anderen Comonomeren, wie sie in den DE-A 20 64 080 und 23 63 806 beschrieben sind. Die Bindemittel werden in einer Menge von 40 bis 80, vorzugsweise 50 bis 70 Gew.-%, der nichtflüchtigen Bestandteile des Gemischs verwendet.

Als Photoinitiatoren in dem erfindungsgemäßen Gemisch können eine Vielzahl von Substanzen Verwendung finden. Beispiele sind Benzoin und seine Derivate, Mehrkernchinone, Trichlormethyl-s-triazine, Acridinderivate, z. B. 9-Phenyl-acridin, 9-p-Methoxy-phenyl-acridin, 9-Acetylamino-acridin, Benz(a)acridin ; Phenazinderivate, z. B. 9,10-Dimethylbenz(a)phenazin, 9-Methyl-benz(a)phenazin, 10-Methoxybenz(a)-phenazin, Chinoxalinderivate, z. B. 6,4',4"-Trimethoxy-2,3-diphenylchinoxalin, 4'4"-Dimethoxy-2,3-diphenyl-5-azachinoxalin oder Chinazolinderivate. Die Acridin-, Phenazin- und Chinoxalinderivate werden bevorzugt. Die Photoinitiatoren werden allgemein in einer Menge von 0,01 bis 10, vorzugsweise von 0,05 bis 2 Gew.-% verwendet.

Vorzugsweise enthalten die Gemische mindestens einen Farbstoff, um die entwickelte Resistschablone besser sichtbar zu machen. Dabei wird mit Vorteil eine Kombination von mindestens zwei Farbstoffen verwendet, von denen der eine bei Bestrahlung seine Farbe ändert und bei Temperaturen oberhalb 200 °C zerstört, d. h. farblos wird. Der andere Farbstoff soll sowohl die Bestrahlung als auch Temperaturen oberhalb 200 °C ohne Veränderung überstehen. Er soll die Lötstopmaske während des Lötens und danach deutlich sichtbar machen.

Als Farbstoffe, die bei Belichtung einen Farbumschlag zeigen, sind z. B. Triphenylmethanfarbstoffe und bestimmte Azofarbstoffe, wie sie in der DE-A 28 07 933 beschrieben sind, geeignet.

Als licht- und hitzebeständige Farbstoffe sind Oxazolonfarbstoffe, z. B. ein Farbstoff der Formel

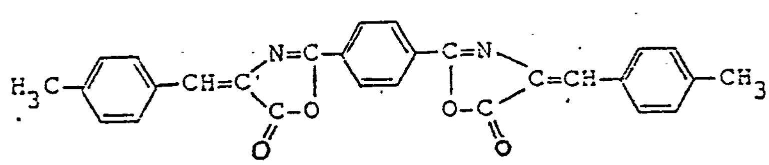

oder Anthrachinonfarbstoffe, z. B. das 1,4-Bis-(4-tert. butoxy-phenylamino)-5,8-dihydroxy-anthrachinon, geeignet.

Die erfindungsgemäßen Gemische können außer Monomeren, Bindemitteln, Photoinitiatoren und Farbstoffen noch eine Reihe weiterer üblicher Zusätze enthalten, z. B. Inhibitoren zur Verhinderung der thermischen Polymerisation der Monomeren, Wasserstoffdonatoren, sensitometrische Regler, Pigmente und Weichmacher.

Das erfindungsgemäße Gemisch findet bevorzugt Anwendung als Photoresist, insbesondere als Lötstopmaske. Dazu kann es in bekannter Weise aus einer Lösung oder als vorgefertigte übertragbare Trockenresistfolie auf das zu bearbeitende Werkstück, z. B. eine Leiterplatte, aufgebracht werden. Das Gemisch wird bevorzugt zu einem Trockenresistmaterial verarbeitet. Im allgemeinen wird eine Lösung des Gemischs in einem Lösemittel auf einen geeigneten Schichtträger, z. B. eine Polyesterfolie, aufgebracht und getrocknet. Die Schichtdicke der Resistschicht kann etwa 10 bis 150, vorzugsweise 20 bis 120 µm betragen. Die freie Oberfläche der Schicht wird vorzugsweise mit einer Deckfolie, z. B. aus Polyethylen oder Polypropylen, abgedeckt. Das fertige Laminat kann als Großrolle gespeichert und bei Bedarf zu Resistrollen beliebiger Breite zerschnitten werden.

Die Resistrollen bleiben auch nach einer Lagerung von Monaten bei 20 °C unverändert und lassen sich problemlos verarbeiten, die Schnittkanten sind völlig frei von zur Verklebung führenden Resistaustritten. Die über 2 Monate bei 40 °C im Trockenschrank gelagerten Resistschichten zeigen gegenüber frisch hergestellten Schichten keinen Unterschied bezüglich Laminierbarkeit, Entwickelbarkeit und Lötresistenz.

Die Folien lassen sich mit in der Trockenresisttechnik üblichen Geräten verarbeiten. In einer handelsüblichen Laminiervorrichtung wird die Deckfolie abgezogen und die Lötstopresistschicht auf die zu schützende, z. B. mit metallisierten Bohrungen versehene, Leiterplatte laminiert. Die so präparierte Platte wird dann durch eine Vorlage belichtet, die die Teile der Platte vor der Bestrahlung schützt, die für den Lötvorgang freibleiben müssen.

Entwickelt werden die von der Trägerfolie befreiten Resistschichten in bekannter Weise. Als Entwickler sind wäßrig-alkalische Lösungen, z. B. von Alkaliphosphaten, -carbonaten oder -silikaten, geeignet, denen gegebenenfalls kleine Mengen, z. B. bis zu 10 Gew.-% an mit Wasser mischbaren organischen Lösemitteln oder Netzmitteln zugesetzt werden können.

Fertig präparierte, nach den eben beschriebenen Verfahrensschritten abgedeckte Leiterplatten müssen nun vor dem Lötprozeß einer Temperaturbehandlung unterzogen werden.

Es wird angenommen, daß sich hierbei ein interpenetrierendes Netzwerk ausbildet, das die guten mechanischen, thermischen und chemischen Eigenschaften der Lötstopmasken bewirkt. Diese thermische Behandlung erfolgt im allgemeinen zwischen 80 °C und 150 °C, bei ungefähren Behandlungszeiten von 10 bis 60 Minuten.

Die lötbereite Platte kann mit elektronischen Bauelementen bestückt werden, deren Anschlußstücke über die entsprechenden Leitungen der Schaltung in den Bereichen, die im Entwicklungsprozeß freigelegt wurden, gebogen werden.

Die Leitungsseite der Platte kann dann mit einem passenden, handelsüblichen Flußmittel behandelt und über eine handelsübliche Schwall-Lötmaschine der Schwall-Lötung unterworfen werden.

Als Lötmittel dienen bekannte eutektische Gemische, die Löttemperaturen von etwa 230° bis 260 °C gestatten. Ein bekanntes Gemisch enthält beispielsweise 63 Gew.-% Zinn und 37 Gew.-% Blei.

Auch für Verfahren, bei denen doppelseitige, durchkontaktierte Leiterplatten durch Eintauchen in flüssige Metallbäder gelötet werden, lassen sich die erfindungsgemäßen Lötstopmasken mit Erfolg einsetzen.

Die erfindungsgemäßen Gemische ergeben Lötstopresistschichten, die sich durch hohe Flexibilität und mechanische Festigkeit im unbelichteten und belichteten Zustand und durch eine hohe Temperaturresistenz im belichteten und nachgehärteten Zustand auszeichnen. Die photopolymerisierbaren Schichten weisen in Kombination mit den bevorzugten Photoinitiatoren eine hohe Lichtempfindlichkeit auf und ergeben auch bei hoher Schichtdicke eine gute Durchhärtung bzw. Durchvernetzung. Die belichteten Schichten lassen sich auch bei Schichtdicken oberhalb 100 µm einwandfrei und vollständig mit wäßrig-alkalischen Lösungen entwickeln.

Die belichteten und entwickelten Schichten lassen sich ohne übermäßige Beeinträchtigung der Flexibilität der Maske oder ihrer Haftung auf der Unterlage und ohne Veränderung der Lage und Dimensionen der durch Entwicklung freigelegten Bereiche thermisch härten. Die gehärteten Masken sind gegenüber atmosphärischen, thermischen und chemischen Einflüssen über längere Zeiträume beständig. Die aus den erfindungsgemäßen Gemischen erhaltenen Lötstopmasken eignen sich in besonderem Maße dazu, empfindliche elektronische Leiterstrukturen vor atmosphärischen Angriffen wirksam und dauerhaft zu schützen.

Obwohl die Erfindung in der vorstehenden Beschreibung bevorzugt in ihrer Anwendung auf die Herstellung von Lötstopmasken beschrieben wurde, ist sie nicht auf diese Anwendung beschränkt. Sie ist in allen Fällen anwendbar, wo es darauf ankommt, bildmäßige Schablonen von besonders hoher thermischer, mechanischer und chemischer Resistenz zu erzeugen. Das ist der Fall auch bei anderen Photoresistanwendungen, z. B. bei der Erzeugung von Galvanoschablonen, die gegenüber aggressiven Bädern und/oder bei erhöhten Temperaturen resistent sein sollen. Insbesondere ist das erfindungsgemäße Gemisch auch zur Herstellung von Offsetdruckplatten, z. B. auf Aluminium, Stahl oder Chrom als Trägermaterial, geeignet, die in bekannter Weise nach dem Entwickeln zur Verfestigung der Bildschablone eingebrannt werden sollen. Dieses Verfahren ist in der GB-A-1 154 749 beschrieben. Bei dieser Anwendungsweise sollte allerdings kürzere Zeit und auf höhere Temperaturen erhitzt werden, im allgemeinen 2 bis 20 Minuten auf Temperaturen im Bereich von 200 bis 250 °C. Hierdurch kann auch die Druckauflage von photopolymerisierbaren Offsetdruckplatten wesentlich gesteigert werden.

Die folgenden Beispiele erläutern einzelne Ausführungsformen des erfindungsgemäßen Gemischs. Wenn nichts anderes angegeben ist, sind Prozentzahlen und Mengenverhältnisse in Gewichtseinheiten zu verstehen. Die Gewichtsteile (Gt) verhalten sich zu den Volumteilen (Vt) wie Gramm zu Milliliter.

## Beispiel 1

Zu je einer Lösung aus :

13 Gt eines Terpolymerisates aus n-Hexylmethacrylat, Methacrylsäure und Styrol (60 : 30 : 10) mit einem mittleren Molgewicht von ca. 35.000 und der Säurezahl 195,

6,4 Gt Polyethylenglykol-400-dimethacrylat,

1,6 Gt des unten beschriebenen Elastomeren,

0,2 Gt 9-Phenyl-acridin,

0,01 Gt eines blauen Farbstoffs, erhalten durch Kuppeln von 2,4-Dinitro-6-chlor-benzoldiazoniumsalz mit 2-Methoxy-5-acetylamino-N,N-diethylanilin und

0,03 Gt 1,4-Bis-(4-tert.butoxy-phenylamino)-5,8-dihydroxy-anthrachinon in

30,0 Gt Butanon und

5,0 Gt Ethanol

wurden folgende vernetzbare Verbindungen in den angegebenen Mengen zugesetzt :

a) 0,6 Gt 2,2-Bis-(4-glycidoxy-phenyl) propan (0,003 16 Mol Epoxygruppen = 7 Mol-% bezogen auf COOH-Gruppen im Bindemittel),

b) 0,21 Gt Hexamethoxymethylmelamin (0,003 16 Mol Methoxymethylgruppen = 7 Mol-% bezogen auf COOH-Gruppen im Bindemittel),

c) 0,21 Gt ankondensiertes Hexamethoxymethylmelamin ($\approx$ 0,003 Mol Methoxymethylgruppen $\approx$ 7 Mol-% bezogen auf COOH-Gruppen im Bindemittel),

d) 0,28 Gt Tetramethylol-Bisphenol-A (0,003 16 Mol Hydroxymethylgruppen = 7 Mol-% bezogen auf COOH = Gruppen im Bindemittel),

e) 0,16 Gt Hexamethylolmelamin (0,003 16 Mol Hydroxymethylgruppen = 7 Mol-% bezogen auf COOH-Gruppen im Bindemittel),

f) 0,31 Gt Triglycidylisocyanurat (0,003 16 Mol Epoxygruppen = 7 Mol-% bezogen auf COOH-Gruppen im Bindemittel),

g) 1,2 Gt 2,2-Bis-(4-glycidoxy-phenyl) propan (0,006 32 Mol Epoxygruppen = 14 Mol-% bezogen auf COOH-Gruppen im Bindemittel),

h) 0,41 Gt Hexamethoxymethylmelamin (0,006 32 Mol Methoxymethylgruppen = 14 Mol-% bezogen auf COOH-Gruppen im Bindemittel),

i) 0,41 Gt ankondensiertes Hexamethoxymethylmelamin ($\approx$ 0,006 Mol Methoxymethylgruppen $\approx$ 14 Mol-% bezogen auf COOH-Gruppen im Bindemittel),

k) 0,55 Gt Tetramethylol-Bisphenol-A (0,006 32 Mol Hydroxymethylgruppen = 14 Mol-% bezogen auf COOH-Gruppen im Bindemittel),

l) 0,32 Gt Hexamethylolmelamin (0,006 32 Mol Hydroxymethylgruppen = 14 Mol-% bezogen auf COOH-Gruppen im Bindemittel),

m) 0,19 Gt Dimethylolharnstoff (0,003 16 Mol Hydroxymethylgruppen = 14 Mol-% bezogen auf COOH-Gruppen im Bindemittel),

n) 0,41 Gt Bismethoxymethyldiphenylether (0,003 16 Mol Methoxymethylgruppen = 7 Mol-% bezogen auf COOH-Gruppen im Bindemittel.

Das verwendete Elastomere wurde wie folgt hergestellt :

A. In einem 1-Liter-Vierhalskolben, ausgerüstet mit Rührer, Thermometer, Rückflußkühler und Trockenrohr, wurden 426 Gt Glycidylmethacrylat und 216 Gt Adipinsäure durch Rühren vermischt und nach Zugabe von 19,7 Gt p-Methoxy-phenol und 6,4 Gt Benzyl-triethyl-ammoniumchlorid vorsichtig auf eine Innentemperatur von 80 °C erhitzt. Nach ca. 2 Stunden wurde eine klare Lösung erhalten, die noch 14 Stunden bei 80 °C gehalten wurde. Der Gehalt an freiem Glycidylmethacrylat war nach dieser Zeit kleiner als 0,5 %.

B. In einem mit Rührer, Thermometer, Tropftrichter, Kühler und Trockenrohr bestückten 1-Liter-Vierhalskolben wurden 143 Gt eines oligomeren Diisocyanats der Formel

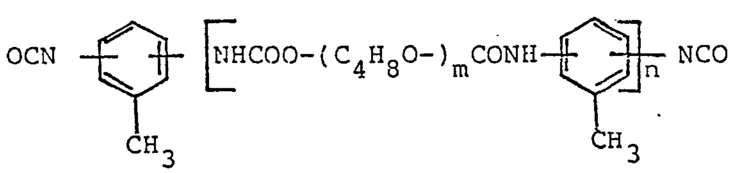

mit einem mittleren Molekulargewicht um 2 000 und einem Isocyanatgruppengehalt von 4,1 Gew.-% (Adiprene®L 100), gelöst in 300 Vt Methylethylketon, gegeben und mit 0,87 Gt Benzochinon und 0,85 Vt einer Lösung versetzt, die durch Lösen von 6,3 Gt Eisen-III-acetylacetonat und 0,45 Gt Triethylamin in Methylethylketon und Auffüllen mit Methylethylketon auf 100 Vt hergestellt wurde. In den Tropftrichter wurde eine Lösung von 31,33 Gt des nach A erhaltenen Umsetzungsproduktes in 300 Vt Methylethylketon gefüllt und der auf 70 °C erhitzten und gerührten Lösung im Kolben innerhalb 40 Minuten zugetropft. Nach zweistündigem Nachrühren bei 30 °C wurden dem klaren Reaktionsgemisch 10 Vt Ethanol zugesetzt. Durch Abdestillieren des Lösemittels wurde aus der viskosen Lösung eine nicht klebende kautschukartige Masse erhalten, die in zahlreichen organischen Löse-mitteln, wie Tetrahydrofuran, Aceton oder Toluol klar löslich war. Die reduzierte spezifische Viskosität des Produkts betrug 0,72 dl/g (gemessen an einer 1 %igen Lösung in Dimethylformamid bei 25 °C).

Mit den angegebenen Lösungen wurden 110 cm breite Bahnen einer biaxial verstreckten und thermofixierten Polyethylenterephthalatfolie der Stärke 25 µm mittels einer Schlitzdüse kontinuierlich beschichtet. Nach Durchlaufen einer Trockenzone hatten die Resistschichten eine Dicke von jeweils 100 µm und wurden mit einer Polypropylenfolie abgedeckt. Die so gefertigten Trockenresistfolien wurden anschliessend mittels eines Rollenschneiders zu handlichen Resistrollen einer Breite von 45 cm und einer Bahnlänge von 50 m zerschnitten.

Für die Laminierversuche dienten Testplatten aus Epoxid-Glas-Hartgewebe mit ca. 65 µm starken Leiterbahnen mit einer verzinnten Oberfläche und durchkontaktierten Löchern. Die Leiterbahnbreiten und -abstände lagen zwischen 200 und 1 000 µm, die Lochdurchmesser betrugen 0,6 bis 4 mm.

Auf diese Platten wurden die 100 µm starken Lötstopresistschichten mit einer handelsüblichen Laminiervorrichtung bei 120 °C laminiert.

Dann wurden die Platten durch eine Belichtungsvorlage, die die zu lötenden Augen und Löcher abdeckte, mit einem handelsüblichen Belichtungsgerät mit 5 kW-Metallhalogenid-Lampe 10 Sekunden belichtet, in einem handelsüblichen Sprühprozessor 100 Sekunden mit 0,8 %iger Sodalösung entwickelt und trocken geblasen. Die so präparierten Leiterplatten wurden dann in einem Trockenschrank 60 Minuten bei 150 °C gehärtet. Die abgekühlten Platten wurden anschließend mit dem Flußmittel TL 33-16 der Firma Alpha Grillo benetzt und sodann mit einer Geschwindigkeit von 0,5 m/min über ein handelsübliches Schwallötbad von 250 °C geführt.

Nach diesem Verfahren wurden Platten mit staubtrockener, sehr schlag- und kratzfester Oberfläche erhalten. Auch schmale Leiterzüge waren von der gehärteten Lötstopschicht fest umhüllt.

Zur Bestimmung der Lagerfähigkeit wurden Proben der oben beschriebenen Trockenresistmaterialien bei 40 °C im Trockenschrank gelagert. Täglich wurde jeweils eine Probe entnommen und wie oben beschrieben laminiert, belichtet und entwickelt.

In der folgenden Tabelle ist als Lagerfähigkeit der verschiedenen Resistschichten die Anzahl der Tage angegeben, nach denen sich die Schicht noch vollständig entwickeln ließ :

| Schicht | a | b | c | d | e | f | g | h | i | k | l | m |
|---|---|---|---|---|---|---|---|---|---|---|---|---|
| Lagerfähigkeit (Tage bei 40°C) | 10 | >80 | >67 | >77 | >70 | 39 | 5 | >72 | >61 | >70 | >70 | >61 |

Anzumerken ist, daß eine Einbrenndauer von 60 Minuten nicht unbedingt erforderlich ist. So zeigen z. B. die Schichten b und c schon nach 30 Minuten, die Schicht f bereits nach 15 Minuten eine ausreichende Lötresistenz.

Die Einbrenndauer kann weiterhin durch eine längere Belichtungszeit verkürzt werden.

## Beispiele 2-7

In der folgenden Tabelle sind 6 Beispiele summiert, die sich in der technischen Durchführung nicht von Beispiel 1 unterschieden, jedoch rezeptuelle Unterschiede aufweisen.

Dadurch bedingte Eigenschaftsvarianten der Resists sind in der Tabelle stichwortartig notiert. Als Bindemittel wurden in allen 6 Beispielen 13 Gt des in Beispiel 1 angegebenen Terpolymerisats verwendet. Es wurden ferner das in Beispiel 1 angegebene Polyurethanmonomere sowie Photoinitiator und Farbstoffe in den gleichen Mengen wie dort zugesetzt. Die in den Beispielen 4 und 5 zusätzlich verwendeten thixotropen Urethanmonomeren bewirken eine Verhinderung des Randaustritts der unbelichteten Resistschicht.

(Siehe Tabelle Seite 9 f.)

| Beispiel | niedermolekulares Monomeres (PEG-400-DMA*) Gt | niedermolekulares Zusatzmonomeres, Gt | ankondensiertes Hexamethoxymethylmelamin Gt | Bemerkungen | Lagerfähigkeit, Tage bei 40°C |
|---|---|---|---|---|---|
| 2 | - | PPG-420-DMA ** 6,4 | 0,21 | geringfügig sprödere Schicht als mit PEG-400-DMA | >76 |
| 3 | 4,8 | PPG-420-DMA ** 1,6 | 0,21 | hohe Lichtempfindlichkeit, kein Randaustritt, gute Lagerfähigkeit | >76 |
| 4 | 4,8 | Oligourethan aus PEG 300, Hexamethylendiisocyanat und Glycerindimethacrylat 1,6 | 0,21 | Kein Randaustritt | >76 |
| 5 | 4,8 | Oligourethan aus PPG 400, Hexamethylendiisocyanat und Glycerindimethacrylat 1,6 | 0,21 | Kein Randaustritt | >76 |
| 6 | 5,2 | - | 0,8 | Hohe Vernetzungsgeschwindigkeit Gute Lagerstabilität | >168 |
| 7 | 4,8 | - | 1,6 | Hohe Vernetzungsgeschwindigkeit Gute Lagerstabilität | > 66 |

*Polyethylenglykol-400-dimethacrylat
**Polypropylenglykol-420-dimethacrylat

Beispiel 8

Zu je einer Lösung aus

13 Gt des in Beispiel 1 angegebenen Terpolymerisats,
1,6 Gt des Elastomeren aus Beispiel 1,
0,2 Gt 9-Phenyl-acridin,
0,03 Gt 1,4-Bis-(4-tert.butoxy-phenylamino)-5,8-dihydroxy-anthrachinon und
0,01 Gt des in Beispiel 1 angegebenen blauen Farbstoffs in
30 Gt Butanon und
5 Gt Ethanol

wurden folgende Mengen an niedermolekularem Monomeren und vernetzbarer Verbindung zugesetzt:

a) 6,4 Gt PEG-400-DMA
0,2 Gt Hexamethoxymethylmelamin
b) 5,2 Gt PEG-400-DMA
0,2 Gt Hexamethoxymethylmelamin
c) 5,2 Gt PEG-400-DMA
0,8 Gt Hexamethoxymethylmelamin
d) 6,4 Gt PEG-400-DMA
0,24 Gt Triglycidylisocyanurat.

Mit Lösungen der angegebenen Zusammensetzung wurden wie in Beispiel 1 beschrieben Resistrollen mit einer Breite von 45 cm und einer Bahnlänge von 50 m hergestellt.

Die Trockenresistfolien wurden mit einer handelsüblichen Laminiervorrichtung bei 120 °C auf mit 35 µm starker Kupferfolie kaschierte Phenoplast-Schichtstoffplatten laminiert und jeweils 10 Sekunden mittels einer 5 kW-Metallhalogenidlampe belichtet. Als Vorlage diente eine Strichvorlage mit Linienbreiten und Abständen bis herab zu 80 µm.

Nach der Belichtung wurde die Polyesterfolie abgezogen, und die Schichten wurden mit 0,8 %iger Sodalösung in einem Srpühentwicklungsgerät 180 Sekunden lang entwickelt.

Die Platten wurden dann 30 Sekunden mit Leitungswasser gespült, 30 Sekunden in einer 15 %igen Ammoniumperoxydisulfat-Lösung angeätzt, erneut mit Wasser gespült, 30 Sekunden in 10 %ige Schwefelsäure getaucht und sodann in den folgenden Elektrolytbädern galvanisiert:

1) 120 Minuten in einem Kupferelektrolytbad der Firma Schlötter, Geislingen/Steige, Typ « Glanzkupfer® Bad », Stromdichte: 2,5 A/dm², Metallaufbau: ca. 100 µm, Temperatur: Raumtemperatur.

2) 2 Minuten in einem Nickelbad Typ « Normal® » der Firma Schlötter, Geislingen/Steige, Stromdichte: 4 A/dm², Metallaufbau: 2 µm, Temperatur: 50 °C.

Die Platten zeigten keinerlei Unterwanderungen oder Beschädigungen.

Die Platten konnten sodann in 5 %iger KOH-Lösung bei 50 °C entschichtet werden und das freigelegte Kupfer in den üblichen Ätzmedien weggeätzt werden.

Beispiel 9

Auf elektrochemisch aufgerauhtes und anodisiertes Aluminium mit einer Oxidschicht von 2 g/m², das mit einer wäßrigen Lösung von Polyvinylphosphonsäure vorbehandelt worden war, wurden folgende Beschichtungslösungen aufgeschleudert:

a) 2 Gt eines Mischpolymerisats aus Styrol und Maleinsäuremonobutylester (1:1, Molekulargewicht ca. 68 000),
2 Gt eines Diurethans aus 2 Mol Glycerindimethacrylat und 1 Mol Hexamethylendiisocyanat,
0,7 Gt 9-Phenyl-acridin und
0,07 Gt eines blauen Farbstoffs, erhalten durch Kuppeln von 2,4-Dinitro-6-chlor-benzoldiazoniumsalz mit 2-Methoxy-5-acetylamino-N-cyanethyl-N-hydroxyethyl-anilin in
24 Gt Butanon,
10 Gt Butylacetat und
10 Gt Ethylenglykolmonomethylether,

b) eine Beschichtungslösung wie a, die zusätzlich 0,027 Gt teilweise ankondensiertes Hexamethoxymethylmelamin enthielt.

Anschließend wurden die Platten 2 Minuten bei 100 °C im Umlufttrockenschrank getrocknet. Es wurde ein Schichtgewicht von 2,5 g/m² erhalten.

Die erhaltenen Druckplatten wurden mittels einer 5 kW-Metallhalogenidlampe im Abstand von 110 cm zwischen Lampe und Vakuumkopierrahmen unter einem 13-stufigen Belichtungskeil mit Dichteinkrementen von 0,15 40 Sekunden belichtet. Anschließend wurden die Platten manuell mit einem Entwickler folgender Zusammensetzung entwickelt:

3,0 Gt Natriummetasilikat x 9 $H_2O$,
0,03 Gt nichtionogenes Netzmittel (Kokosfettalkohol-Polyoxyethylenether mit ca. 8 Oxyethyleneinheiten),
0,003 Gt Antischaummittel,
0,02 Gt Nitrilotriessigsäure,

0,053 Gt Strontiumchlorid x 6 $H_2O$,
96,894 Gt vollentsalztes Wasser.
Es wurden 7 bis 8 vollvernetzte Keilstufen erhalten.

Die mit der Lösung b beschichtete Platte wurde nach dem Entwickeln 10 Minuten bei 230 °C eingebrannt und ergab eine wesentlich erhöhte Druckauflage.

**Patentansprüche**

1. Durch Strahlung polymerisierbares Gemisch, enthaltend

a) eine Verbindung mit mindestens zwei endständigen ethylenisch ungesättigten Gruppen, die durch radikalisch initiierte Additionskettenpolymerisation ein vernetztes Polymerisat zu bilden vermag,

b) ein gesättigtes polymeres Bindemittel, das wasserunlöslich und in wäßrig-alkalischen Lösungen löslich ist, und

c) einen durch Strahlung aktivierbaren Polymerisationsinitiator dadurch gekennzeichnet, daß es zusätzlich

d) eine mit dem polymeren Bindemittel b, mit dem Polymerisationsprodukt der Verbindung a und/oder mit sich selbst thermisch vernetzbare Verbindung enthält, die, sofern sie als vernetzende Gruppen Epoxygruppen enthält, mindestens drei Epoxygruppen aufweist.

2. Durch Strahlung polymerisierbares Gemisch nach Anspruch 1, dadurch gekennzeichnet, daß die vernetzbare Verbindung in einer Menge von 0,5 bis 30 Gew.-% darin enthalten ist.

3. Durch Strahlung polymerisierbares Gemisch nach Anspruch 1, dadurch gekennzeichnet, daß die vernetzbare Verbindung als vernetzende Gruppen Epoxygruppen oder Gruppen der Formel

$$—CH_2—O—R$$

enthält, worin R ein Wasserstoffatom, eine Alkyl-, Acyl- oder Hydroxyalkylgruppe mit 1 bis 4 C-Atomen ist, und die Gruppen $—CH_2OR$ an einem Stickstoffatom eines offenkettigen oder cyclischen Säureamids oder an einem aromatischen Kohlenstoffatom einer zur Kondensation mit Formaldehyd befähigten Verbindung stehen.

4. Durch Strahlung polymerisierbares Gemisch nach Anspruch 1, dadurch gekennzeichnet, daß die vernetzbare Verbindung mindestens zwei vernetzende Gruppen enthält.

5. Durch Strahlung polymerisierbares Gemisch nach Anspruch 1, dadurch gekennzeichnet, daß es als vernetzbare Verbindung eine Epoxyverbindung enthält, die in dem verwendeten Beschichtungslösungsmittel unlöslich ist.

6. Durch Strahlung polymerisierbares Gemisch nach Anspruch 1, dadurch gekennzeichnet, daß die Verbindung mit mindestens zwei endständigen ethylenisch ungesättigten Gruppen als ungesättigte Gruppen Acryl- oder Methacrylsäureestergruppen enthält.

7. Photopolymerisierbares Kopiermaterial mit einem flexiblen transparenten temporären Schichtträger und einer übertragbaren thermoplastischen photopolymerisierbaren Schicht, die

a) eine Verbindung mit mindestens zwei endständigen ethylenisch ungesättigten Gruppen, die durch radikalisch initiierte Additionskettenpolymerisation ein vernetztes Polymerisat zu bilden vermag,

b) ein gesättigtes polymeres Bindemittel, das wasserunlöslich und in wäßrig-alkalischen Lösungen löslich ist, und

c) einen Photopolymerisationsinitiator

enthält, dadurch gekennzeichnet, daß die Schicht zusätzlich

d) eine mit dem polymeren Bindemittel b, mit dem Polymerisationsprodukt der Verbindung a und/oder mit sich selbst thermisch vernetzbare Verbindung enthält, die, sofern sie als vernetzende Gruppen Epoxygruppen enthält, mindestens drei Epoxygruppen aufweist.

**Claims**

1. A radiation-polymerizable mixture containing

a) a compound which has at least two terminal ethylenically unsaturated groups and which can form a cross-linked polymer by means of chain polymerization by addition which is initiated by free radicals,

b) a saturated polymeric binder which is insoluble in water and soluble in aqueous-alkaline solutions and

c) a polymerization initiator which can be activated by radiation, which contains in addition

d) a compound which is thermally crosslinkable with the polymeric binder b, with the polymerization product of compound a and/or with itself and which, provided its crosslinking groups are epoxy groups, has at least three epoxy groups.

2. A radiation-polymerizable mixture as claimed in claim 2, which contains the crosslinkable compound in an amount of 0.5 to 30 % by weight.

3. A radiation-polymerizable mixture as claimed in claim 1, wherein the crosslinkable compound contains, as crosslinking groups, epoxy groups or groups of the formula

$$-CH_2-OR$$

in which R is a hydrogen atom or an alkyl, acyl or hydroxyalkyl group having from 1 to 4 carbon atoms, and the groups $-CH_2OR$ are bonded to a nitrogen atom of an open-chain or cyclic acidamide or to an aromatic carbon atom of a compound capable of condensing with formaldehyde.

4. A radiation-polymerizable mixture as claimed in claim 1, wherein the crosslinkable compound contains at least two crosslinking groups.

5. A radiation-polymerizable mixture as claimed in claim 1, which contains as crosslinkable compound an epoxy compound which is insoluble in the coating solvent used.

6. A radiation-polymerizable mixture as claimed in claim 1, wherein the compound having at least two terminal ethylenically unsaturated groups contains as unsaturated groups acrylate or methacrylate groups.

7. A photopolymerizable copying material having a flexible transparent temporary support and a transferable thermoplastic photopolymerizable layer containing

a) a compound which has at least two terminal ethylenically unsaturated groups and which can form a crosslinked polymer by means of chain polymerization by addition which is initiated by free radicals,

b) a saturated polymeric binder which is insoluble in water and soluble in aqueous-alkaline solutions and

c) a polymerization initiator, wherein the layer additionally contains

d) a compound which is thermally crosslinkable with the polymeric binder b, with the polymerization product of compound a and/or with itself and which, provided its crosslinking groups are epoxy groups, has at least three epoxy groups.

**Revendications**

1. Mélange polymérisable par irradiation contenant

a) un composé possédant au moins deux groupes terminaux à insaturation éthylénique, qui est capable de former un polymère réticulé par polymérisation en chaîne par addition amorcée par des radicaux libres,

b) un liant polymère saturé qui est insoluble dans l'eau et qui est soluble dans des solutions aqueuses alcalines, et

c) un initiateur de polymérisation pouvant être activé par irradiation, caractérisé en ce qu'il contient en plus

d) un composé réticulable à la chaleur avec le liant polymère b), avec le produit de polymérisation du composé a) et/ou avec lui-même, qui comporte, dans la mesure où il contient en tant que groupes réticulants des groupes époxy, au moins trois groupes époxy.

2. Mélange polymérisable par irradiation selon la revendication 1, caractérisé en ce que le composé réticulable y est contenu en une quantité allant de 0,5 à 30 % en poids.

3. Mélange polymérisable par irradiation selon la revendication 1, caractérisé en ce que le composé réticulable contient en tant que groupes réticulants des groupes époxy ou des groupes de formule

$$-CH_2OR$$

dans laquelle R est un atome d'hydrogène, un radical alkyle, acyle ou hydroxyalkyle ayant de 1 à 4 atomes de carbone, et les groupes $-CH_2OR$ sont situés sur un atome d'azote d'un amide à chaîne ouverte ou cyclique ou sur un atome de carbone aromatique d'un composé susceptible de condensation avec le formaldéhyde.

4. Mélange polymérisable par irradiation selon la revendication 1, caractérisé en ce que le composé réticulable contient au moins deux groupes réticulants.

5. Mélange polymérisable par irradiation selon la revendication 1, caractérisé en ce qu'il contient en tant que composé réticulable un composé époxy qui est insoluble dans le solvant de revêtement utilisé.

6. Mélange polymérisable par irradiation selon la revendication 1, caractérisé en ce que le composé ayant au moins deux groupes terminaux à insaturation éthylénique contient en tant que groupes non saturés des groupes ester d'acide acrylique ou méthacrylique.

7. Matériau de reproduction photopolymérisable comportant un support de couche temporaire transparent flexible et une couche photopolymérisable thermoplastique transférable qui contient

a) un composé possédant au moins deux groupes terminaux à insaturation éthylénique, qui est capable de former un polymère réticulé par polymérisation en chaîne par addition amorcée par des radicaux libres,

b) un liant polymère saturé qui est insoluble dans l'eau et qui est soluble dans des solutions aqueuses alcalines, et

c) un initiateur de photopolymérisation, caractérisé en ce que la couche contient en plus

d) un composé réticulable à la chaleur avec le liant polymère b), avec le produit de polymérisation du composé a) et/ou avec lui-même, qui comporte, dans la mesure où il contient en tant que groupes réticulants des groupes époxy, au moins trois groupes époxy.